Europäisches Patentamt

European Patent Office

Office européen des brevets

(19)

(11) Veröffentlichungsnummer : **0 640 219 B1**

(12) **EUROPÄISCHE PATENTSCHRIFT**

(45) Veröffentlichungstag der Patentschrift :
15.11.95 Patentblatt 95/46

(21) Anmeldenummer : 93905147.0

(22) Anmeldetag : 17.02.93

(86) Internationale Anmeldenummer :
PCT/DE93/00170

(87) Internationale Veröffentlichungsnummer :
WO 93/23758 25.11.93 Gazette 93/28

(51) Int. Cl.⁶ : **G01R 27/22,** G01N 27/06

(54) **INTEGRIERBARE LEITFÄHIGKEITSMESSVORRICHTUNG.**

(30) Priorität : **15.05.92 DE 4216176**

(43) Veröffentlichungstag der Anmeldung :
**01.03.95 Patentblatt 95/09**

(45) Bekanntmachung des Hinweises auf die
Patenterteilung :
**15.11.95 Patentblatt 95/46**

(84) Benannte Vertragsstaaten :
**CH DE FR GB LI NL**

(56) Entgegenhaltungen :
**WO-A-92/18856**
**DE-A- 3 705 714**
**US-A- 4 010 715**
**US-A- 4 656 427**

(73) Patentinhaber :
**FRAUNHOFER-GESELLSCHAFT ZUR**
**FÖRDERUNG DER ANGEWANDTEN**
**FORSCHUNG E.V.**
**Leonrodstrasse 54**
**D-80636 München (DE)**

(72) Erfinder : **KORDAS, Norbert**
**Lydiastrasse 12**
**D-45131 Essen (DE)**
Erfinder : **MANOLI, Yiannos**
**Duppenbäcker Weg 28a**
**D-45481 Mülheim (DE)**

(74) Vertreter : **Schoppe, Fritz, Dipl.-Ing. et al**
**Patentanwalt,**
**Georg-Kalb-Strasse 9**
**D-82049 Pullach (DE)**

## Beschreibung

Die vorliegende Erfindung betrifft eine integrierbare Leitfähigkeitsmeßvorrichtung zur Messung der elektrischen Leitfähigkeit von Flüssigkeiten.

Es ist allgemein bekannt, zum Zwecke der Bestimmung der elektrischen Leitfähigkeit einer Flüssigkeit in diese einen Strom einzuprägen und den Spannungsabfall innerhalb der Flüssigkeit, welcher umgekehrt proportional zur Leitfähigkeit der Flüssigkeit ist, zu messen.

Im einfachsten Fall werden hierzu lediglich zwei Elektroden benutzt. Über diese zwei Elektroden wird der Strom in die Flüssigkeit eingeprägt und gleichzeitig der Spannungsabfall über dieselben Elektroden gemessen. Hierbei treten sogenannte Polarisationseffekte auf, die das eigentliche Meßsignal verfälschen. Diese Effekte treten immer dann auf, wenn ein Strom über eine Grenzschicht zwischen einer Elektrode und einem Elektrolyt fließt. Da in einem Elektrolyten ein Stromfluß mit der Wanderung von Ionen verbunden ist, bilden sich an der Grenzschicht zwischen dem Elektrolyten und der Elektrode Ansammlungen von Ionen eines Ladungstypes, die das ursprüngliche Feld schwächen und das Meßsignal vermindern.

Um diesen Nachteil zu vermeiden, werden Leitfähigkeitsmeßvorrichtungen mit sogenannten Vier-Elektroden-Anordnungen verwendet, bei denen eine Stromquelle mit zwei Stromelektroden zur Einprägung eines Meßstromes vorgesehen ist. Zwei weitere Elektroden, die als Spannungselektroden bezeichnet werden können, dienen zur Messung der über die Flüssigkeit abfallenden Spannung. Der Spannungsabfall, der durch die Spannungselektroden abgegriffen wird, wird durch einen den Spannungselektroden nachgeschalteten hochohmigen Verstärker verstärkt. Aufgrund der hohen Eingangsimpedanz der Verstärker kann der über die Spannungselektroden fließende Strom gering gehalten werden, so daß bei dieser Meßmethode die Polarisationseffekte reduziert werden, woraus sich eine verbesserte Meßgenauigkeit gegenüber der Leitfähigkeitsmessung mit lediglich zwei Elektroden ergibt. Jedoch führt auch bei der Vier-Elektroden-Anordnung der über die Spannungselektroden fließende Meßstrom zu einer Polarisation und somit zu einer Verfälschung des Meßsignales.

Aus der US 4,656,427 ist bereits eine Leitfähigkeitsmeßvorrichtung der eingangs genannten Art bekannt, welche mit der Vier-Elektroden-Anordnung arbeitet. Zwei Stromelektroden sind mit einem rechteckförmigen Strom beaufschlagbar. Zwei Spannungselektroden, denen Kondensatoren zur Abtrennung von Gleichpotentialen nachgeschaltet sind, dienen zur Erfassung der dynamischen Potentialänderung aufgrund des in die zu messende Flüssigkeit eingeprägten rechteckförmigen Wechselstromes. Dieses Signal wird durch eine nachfolgende Auswertungsschaltung, die über einen zusätzlichen, in Reihe geschalteten Kondensator zur Abtrennung von Offset-Strömen verfügt, verstärkt und nach Analog-Digital-Wandlung auf einer Anzeigeeinheit dargestellt.

Gleichfalls ist es bekannt, bei Leitfähigkeitsmeßvorrichtungen der soeben geschilderten Art den eingeprägten Strom als sinusförmigen Wechselstrom zu erzeugen, um durch diese Maßnahme Zersetzungsvorgänge in der Flüssigkeit zu vermeiden, die im Falle einer Messung mit eingeprägtem Gleichstrom auftreten würden.

Um diese Probleme der bekannten integrierbaren Leitfähigkeitsmeßvorrichtungen, die mit zwei Spannungselektroden und zwei Stromelektroden ausgeführt sind, auszuräumen, schlägt die ältere, nicht vorveröffentlichte PCT/DE92/00242 (WO 92/18856) vor, daß die Stromquellenvorrichtung einen rechteckförmigen Strom erzeugt, der den beiden Stromelektroden zugeführt wird, und daß die Meßschaltung als Schalter-Kondensator-Schaltung ausgeführt ist, die einen Meßkondensator aufweist, der mit den Spannungselektroden über eine Schaltereinrichtung in zeitlicher Abhängigkeit von dem Verlauf des im wesentlichen rechteckförmigen Stromes koppelbar und trennbar ist.

Mit dem Gegenstand der PCT/DE92/00242 (WO 92/18856) werden die im vorveröffentlichten Stand der Technik auftretenden Meßfehler aufgrund von Polarisationseffekten vollständig vermieden.

Das Einprägen des Stromes in die Flüssigkeit (den Elektrolyten) sowie die Spannungsmessung erfolgen über einen direkten galvanischen Kontakt zwischen der Leitfähigkeitsmeßvorrichtung und dem Elektrolyten. Dazu werden Elektroden benutzt, welche aus Edelmetallen, Stahl oder Kohle bestehen und als sog. "Kohlrausch"-Zellen bezeichnet werden. Der galvanische Kontakt führt jedoch zu unerwünschten elektrochemischen Effekten an der Grenzschicht zwischen den Elektroden und dem Elektrolyten. Zu diesen Effekten zählen:

Zusätzliche Spannungsabfälle, vor allem bei Stromfluß, die meßtechnisch wieder kompensiert werden müssen.

Elektrolysevorgänge, d.h. Entladungen und Abscheidungen von Ionen an den Elektroden.

Absorption von Ionen und Verschmutzung der Elektroden, welche zu Driftfehlern führen können.

Im Falle eines Fehlers besteht ein Gleichstrompfad durch den Elektrolyten, welcher zu dessen Elektrolyse führen kann. Bei bestimmten Anwendungen, wie beispielsweise in der invasiven medizinischen Diagnostik, muß ein solcher Fall durch zusätzliche schaltungstechnische Maßnahmen abgefangen werden.

Durch die galvanische Kopplung wird der Elektrolyt auf ein festes Potential gelegt, was bei bestimmten Anwendungen nicht erwünscht ist.

Die Anwesenheit eines Metalles oder eines anderen leitfähigen Stoffes kann zu unerwünschten chemischen Reaktionen führen, zu denen beispielsweise die katalytische Wirkung von Platin zählt.

Zur Vermeidung der soeben genannten Effekte wurden bereits kontaktlose Meßverfahren zur Bestimmung der Leitfähigkeit von Flüssigkeiten entwickelt, bei denen zwei Prinzipien zu unterscheiden sind: während bei der einen Methode mit einer induktiven Kopplung zwischen einer Meßschaltung und dem Elektrolyten gearbeitet wird, verwendet die andere Methode eine kapazitive Kopplung.

Bei der induktiven Methode übernimmt beispielsweise der in eine geschlossene Röhre eingebrachte Elektrolyt die Kopplung von ansonsten getrennten Wicklungen eines Transformators. An eine Primärwicklung wird eine Wechselspannung angelegt, die im Elektrolyten einen Stromfluß zur Folge hat. Dieser Stromfluß bewirkt in einer Sekundärwicklung eine Spannung, deren Höhe von der Leitfähigkeit des Elektrolyten abhängt. Der apparative Aufwand bei dieser Methode ist jedoch sehr groß.

Eine kapazitive Ankopplung gemäß der anderen, genannten Meßmethode wird dadurch erreicht, daß die Wände des den Elektrolyten enthaltenden Gefäßes zum Teil als Kondensatoren ausgebildet werden. Dabei wird ein Teil eines solchen Kondensators durch eine Metallschicht gebildet, welche von einer dünnen Glasschicht überzogen ist. Die Gegenelektrode bildet jeweils der Elektrolyt. Das elektrische Ersatzschaltbild einer solchen Anordnung besteht aus zwei derartigen Kondensatoren mit dem Ohm'schen Elektrolyt-Widerstand dazwischen. Bei den bekannten kapazitiven Meßmethoden werden diese Elemente in einen Hf-Schwingkreis eingebracht, in dem der Elektrolyt-Widerstand beispielsweise das Dämpfungsverhalten bestimmt, welches dann ausgewertet wird. Ebenso wie bei der induktiven Methode ist auch hier der apparative Aufwand groß. Zusätzlich ist hier infolge der nur kleinen erreichbaren Kapazitäten eine hohe Meßfrequenz erforderlich. Ferner ist kein einfacher linearer Zusammenhang zwischen der Leitfähigkeit und der Meßgröße gegeben.

Ausgehend von dem oben geschilderten Stand der Technik liegt der vorliegenden Erfindung die Aufgabe zugrunde, eine integrierbare Leitfähigkeitsmeßvorrichtung anzugeben, bei der keine Polarisationseffekte auftreten, bei der eine galvanische Verbindung zu der bezüglich ihrer Leitfähigkeit zu messenden Flüssigkeit vermieden wird und die eine einfache Erfassung der Leitfähigkeit der Flüssigkeit ermöglicht.

Diese Aufgabe wird durch eine integrierbare Leitfähigkeitsmeßvorrichtung gemäß Patentanspruch 1 gelöst.

Vom Gegenstand der älteren, nicht vorveröffentlichten PCT/DE92/00242 (WO 92/18856) hebt sich die integrierbare Leitfähigkeitsmeßvorrichtung nach der vorliegenden Anmeldung kurz gesagt dadurch ab, daß zumindest die bei der PCT/DE92/00242 (WO 92/18856) als Stromelektroden ausgeführte Stromzufuhr-Elemente im Sinne der vorliegenden Erfindung als Stromeinkoppel-Kondensatoren ausgebildet sind. Gemäß einem wesentlichen Erfindungsaspekt sind auch die Spannungsmeßelemente als Spannungsauskoppel-Kondensatoren ausgebildet, so daß eine vollständige galvanische Trennung zwischen der Leitfähigkeitsmeßvorrichtung und der bezüglich ihrer Leitfähigkeit zu messenden Flüssigkeit erreicht wird.

Die erfindungsgemäße Leitfähigkeitsmeßvorrichtung basiert auf einer rein kapazitiven Kopplung zwischen der Leitfähigkeitsmeßvorrichtung und der Flüssigkeit bzw. dem Elektrolyten, wobei die Koppelkapazitäten vorzugsweise in integrierter Technik hergestellte Elemente sein können, bei denen sich über einer leitenden Schicht eine dünne Isolierschicht befindet. Die Gegenelektrode wird jeweils durch die Flüssigkeit bzw. den Elektrolyten gebildet. Die so entstehenden Kondensatoren sind in einer ausreichenden Größe herstellbar, die es erlaubt, für eine gewisse Zeitdauer einen konstanten Strom über zwei als Stromzuführelemente dienende Kapazitäten fließen zu lassen. Der resultierende Spannungsabfall in der Flüssigkeit ist für diese Zeitdauer ebenfalls konstant und läßt sich mit Hilfe zweier Spannungsmeßelemente, die als Spannungsauskoppelkondensatoren ausgeführt sind, und die vorzugsweise zwischen den beiden Stromeinkoppel-Kondensatoren angeordnet sind, detektieren und weiterverarbeiten.

Durch die galvanische Trennung ist es bei der erfindungsgemäßen Leitfähigkeitsmeßvorrichtung möglich, die Bildung eines Gleichstrompfades durch den Elektrolyten bzw. die Flüssigkeit zu verhindern. Ferner wird verhindert, daß die Flüssigkeit auf ein festes Potential gelegt wird. Dies ermöglicht die Anwendung der erfindungsgemäßen Leitfähigkeitsvorrichtung in Bereichen mit hohen Sicherheitsanforderungen.

Die Meßschaltung ist monolithisch mit allen Komponenten auf einem Halbleitersubstrat integrierbar. Die geringe Größe der integrierbaren, erfindungsgemäßen Leitfähigkeitsmeßvorrichtung läßt den Einsatz bei kleinen Probenvolumina oder an schwer zugänglichen Stellen zu.

Nachfolgend werden Ausführungsbeispiele der integrierbaren Leitfähigkeitsmeßvorrichtung nach der PCT/DE92/00242 sowie nach der vorliegenden Erfindung unter Bezugnahme auf die beiliegenden Zeichnungen näher erläutert. Es zeigen:

Fig. 1          ein Schaltbild der Leitfähigkeitsmeßvorrichtung nach der PCT/DE92/00242;

Fig. 2 ein Zeitdiagramm von Strömen bzw. Spannungen, wie sie in der Leitfähigkeitsmeßvorrichtung gemäß Fig. 1 auftreten;

Fig. 3a eine Querschnittdarstellung einer Koppelkapazität der erfindungsgemäßen Leitfähigkeitsmeßvorrichtung;

Fig. 3b eine Draufsicht auf die Koppelkapazität gemäß Fig. 3a;

Fig. 4 ein Schaltbild einer Ausführungsform der erfindungsgemäßen Leitfähigkeitsmeßvorrichtung;

Fig. 5a eine Draufsicht auf die Anordnung der Koppelkapazitäten der Leitfähigkeitsmeßvorrichtung gemäß Fig. 4;

Fig. 5b das elektrische Ersatzschaltbild der Anordnung der Koppelkapazitäten gemäß Fig. 5a;

Fig. 6a das wirksame elektrische Ersatzschaltbild der Anordnung der Koppelkapazitäten bei dem Einprägen des Meßstromes;

Fig. 6b Spannungsabfälle an den Elementen des Ersatzschaltbildes;

Fig. 6c Spannungen an Punkten innerhalb des Ersatzschaltbildes;

Fig. 7a das wirksame elektrische Ersatzschaltbild der Anordnung der Koppelkapazitäten gemäß Fig. 5a bei dem Messen der Signalspannung; und

Fig. 7b die zeitlichen Verläufe der Spannungen an dem Meßkondensator der Leitfähigkeitsmeßvorrichtung gemäß Fig. 4.

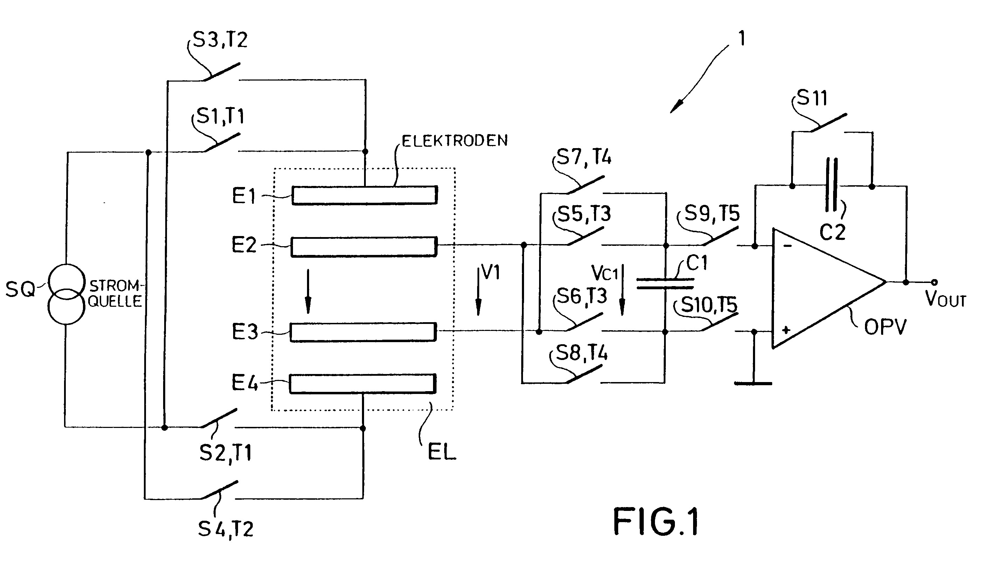

Das in Fig. 1 gezeigte bevorzugte Ausführungsbeispiel der integrierbaren Leitfähigkeitsmeßvorrichtung nach der PCT/DE92/00242, die in ihrer Gesamtheit mit dem Bezugszeichen 1 bezeichnet ist, umfaßt eine Stromquelle SQ zur Erzeugung eines eingeprägten Gleichstromes, welche über einen ersten bis vierten Schalter S1, S2, S3, S4 in Abhängigkeit von deren Schaltzustand in einer ersten Polung oder in einer zu der ersten Polung entgegengesetzten Polung mit zwei Stromelektroden E1, E4 verbindbar ist.

Die Stromelektroden erzeugen in einem Elektrolyt EL einen rechteckförmigen Strom ohne Gleichanteil.

Eine (nicht gezeigte) Steuervorrichtung steuert den ersten bis vierten Schalter S1 bis S4 derart an, daß die Stromquelle SQ alternierend während einer ersten Zeitdauer T1 in der ersten Polung und während einer zweiten Zeitdauer T2 in der zweiten Polung mit den Stromelektroden E1, E4 verbunden wird. Die erste und zweite Zeitdauer T1, T2 sind gleich lang.

Zwischen den Stromelektroden E1, E4 sind zwei Spannungselektroden E2, E3 in dem Elektrolyten EL angeordnet, die den durch den eingeprägten rechteckförmigen Strom zwischen den Stromelektroden E1, E4 über den Elektrolyten auftretenden Spannungsabfall V1 messen.

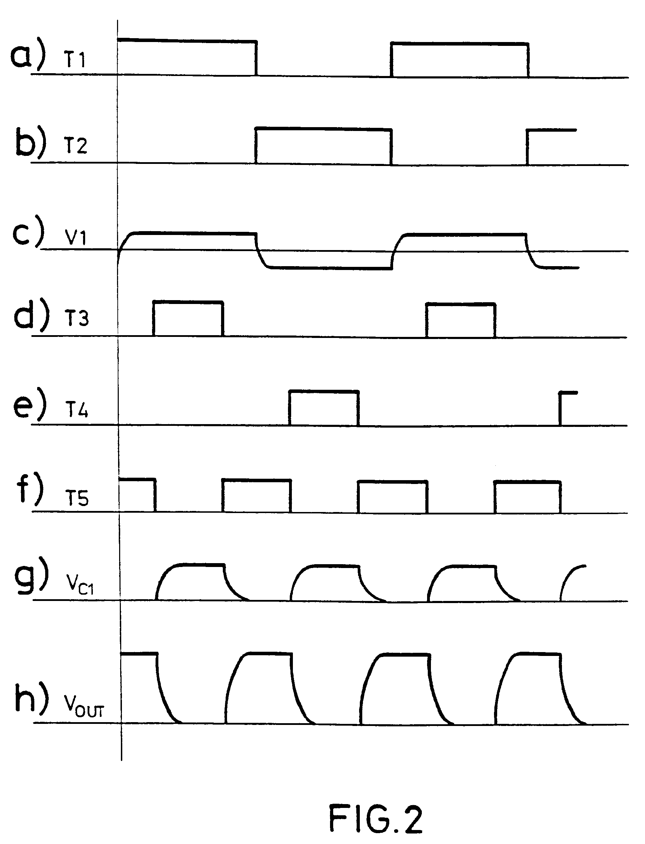

Der zeitliche Verlauf des Spannungsabfalls V1 bezogen auf die erste und zweite Zeitdauer T1, T2 ist in den Fig. 2a bis 2c gezeigt.

Die Spannungselektroden E2, E3 sind über einen fünften bis achten Schalter S5, S6, S7, S8 in einer ersten bzw. zweiten Polung mit den Elektroden eines Meßkondensators C1 verbindbar.

Der fünfte, sechste, siebte und achte Schalter S5 bis S8 werden gleichfalls von der (nicht dargestellten) Steuervorrichtung, die als Mikroprozessor ausgestaltet sein kann, angesteuert. Die Ansteuerung erfolgt derart, daß die Spannungselektroden E2, E3 während einer dritten Zeitdauer T3 in der ersten Polung und während einer vierten Zeitdauer T4 in einer zweiten Polung mit dem Meßkondensator C1 verbunden werden. Wie aus den Fig. 2d, 2e in Hinblick auf die Fig. 2a, 2b ersichtlich ist, liegen die dritte Zeitdauer T3 innerhalb der ersten Zeitdauer T1 und die vierte Zeitdauer T4 innerhalb der zweiten Zeitdauer T2.

Ein neunter und zehnter Schalter S9, S10 liegen zwischen den beiden Elektroden des Meßkondensators C1 und dem invertierenden bzw. nicht-invertierenden Eingang eines Operationsverstärkers OPV, dessen Ausgang über einen Rückkopplungskondensator C2 mit dessen invertierenden Eingang in Verbindung steht.

Die Steuervorrichtung (nicht dargestellt) verbindet jeweils während einer fünften Zeitdauer, die außerhalb der dritten und vierten Zeitdauer T3, T4 liegt, den Meßkondensator C1 mit den Eingängen des Operationsverstärkers OPV. Entsprechend des Kapazitätsverhältnisses des Rückkopplungskondensators C2 und Meßkondensators C1 wird hierdurch die Spannung am Meßkondensator $V_{C1}$ zu einer am Ausgang des Operationsverstärkers erzeugten Spannung $V_{OUT}$ verstärkt.

Bei dem gezeigten Ausführungsbeispiel schließt die (nicht dargestellte) Steuervorrichtung jeweils nach Ablauf der fünften Zeitdauer einen parallel zu dem Rückkopplungskondensator C2 geschalteten elften Schalter S11, so daß die gezeigte Schalter-Kondensator-Schaltung S5 bis S11, C1, C2, OPV als Verstärkerschaltung arbeitet. Es ist jedoch auch möglich, den elften Schalter S11 jeweils nach mehreren Perioden T1, T2 zu schließen, so daß die Schalter-Kondensator-Schaltung in diesem Fall als Integrationsschaltung arbeitet.

Wie sich aus der Betrachtung des Verlaufs des Spannungsabfalls über die Spannungselektroden E2, E3 gemäß Fig. 2c ergibt, sind die erste und zweite Zeitdauer jeweils ausreichend lang gewählt, daß Umschalteffekte abklingen und die Spannung V1 einen im wesentlichen konstanten Wert annimmt. Erst nach Abklingen der Umschaltvorgänge wird während der Zeitdauer T3 der Meßkondensator mit den Spannungselektroden verbunden. Hierdurch fließen Ladungsträger über die Spannungselektroden E2, E3 auf die Elektroden des Meßkondensators C1. Zu Beginn der Zeitdauer T3 führt dieser Stromfluß zu einer Störung des ursprünglichen Feldes zwischen den Stromelektroden E1, E4 und zu einer vorrübergehenden Polarisation. Mit zunehmender Aufladung des Meßkondensators C1 strebt der Meßstrom an den Spannungselektroden E2, E3 exponentiell gegen Null, so daß die Spannungselektroden E2, E3 bei einer hinreichenden Länge der dritten Zeitdauer T3 stromlos werden. Bei einer vom Einzelfall abhängigen, experimentell jedoch leicht bestimmbaren hinreichenden dritten Zeitdauer T3 haben Polarisationseffekte keinen negativen Einfluß mehr auf die erzielbare Meßgenauigkeit.

Die Leitfähigkeitsmeßschaltung eignet sich für eine Integration der Elektroden E1 bis E4, der Stromquellenschaltung SQ und der Verstärkerelektronik einschließlich der Schalter-Kondensator-Schaltung auf einem einzigen Halbleitersubstrat. Durch die monolithische Integration auf einem Halbleitersubstrat kann die Leitfähigkeitsmeßvorrichtung stark miniaturisiert werden, so daß Messungen in kleinen Probenvolumina oder an sonst schwer zugänglichen Stellen, wie beispielsweise im Bereich der invasiven medizinischen Diagnostik, möglich sind.

Die Schaltungsbestandteile können in CMOS-Technologie ausgeführt werden. In diesem Fall kann die Herstellung der Elektroden kompatibel zum CMOS-Prozeß erfolgen, da lediglich der zusätzliche Verfahrensschritt des Aufbringens einer Edelmetallschicht für die Elektroden erforderlich ist.

Obwohl sich die Leitfähigkeitsmeßschaltung vorzugsweise für eine vollständige Integration eignet, können auch Meßschaltungen mit getrennt angeordneten Elektroden nach dem beschriebenen Konzept realisiert werden.

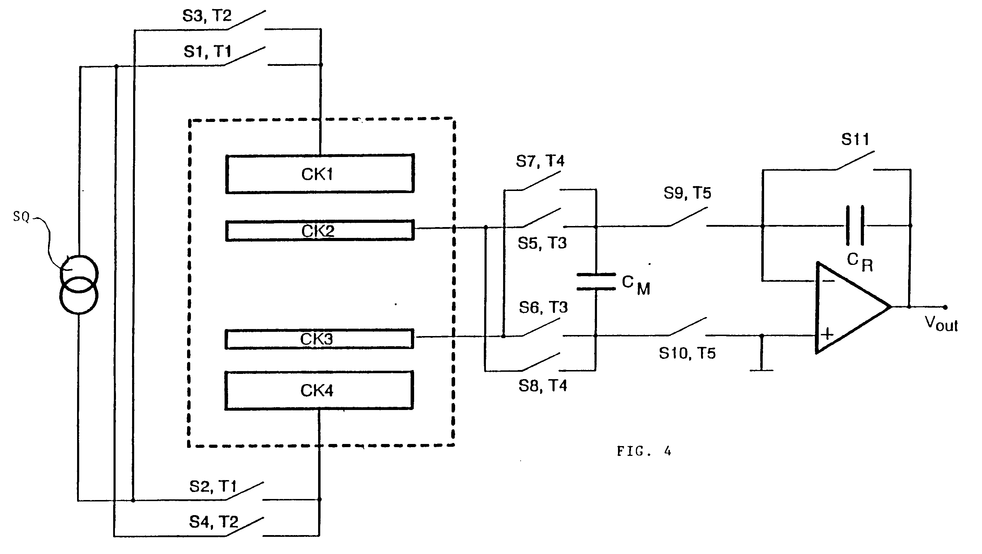

Die erfindungsgemäße integrierbare Leitfähigkeitsmeßvorrichtung hebt sich von der unter Bezugnahme auf Fig. 1 beschriebenen Leitfähigkeitsmeßvorrichtung im wesentlichen dadurch ab, daß die dortigen Elektroden E1 bis E4 durch Koppel-Kondensatoren CK1, CK2, CK3, CK4 ersetzt sind. Im übrigen entspricht die Prinzipschaltung der Fig. 4 identisch derjenigen von Fig. 1, so daß eine erneute Beschreibung der Schaltungsanordnung unterbleiben kann. Lediglich der Vollständigkeit halber sei erwähnt, daß hier der Meßkondensator mit dem Bezugszeichen CM bezeichnet ist, während der Rückkopplungs-Kondensator mit dem Bezugszeichen CR bezeichnet ist.

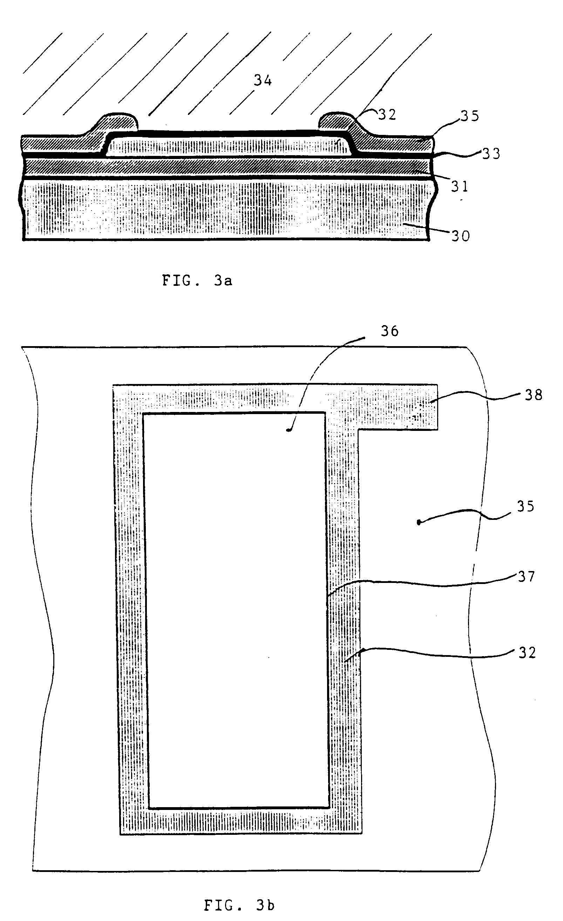

Die Koppel-Kondensatoren können integriert zusammen mit der Leitfähigkeitsmeßvorrichtung ausgebildet sein und haben vorzugsweise die Struktur, die nachfolgend unter Bezugnahme auf die Fig. 3a, 3b beschrieben wird.

Auf einem Halbleitersubstrat 30 ist oberhalb einer Oxidschicht 31, die im Falle eines Silizium-Substrates eine Silizium-Oxid-Schicht 31 ist, eine leitende Schicht vorzugsweise aus Polysilizium 32 angeordnet. Diese Polysiliziumschicht 32 bildet die eine Seite des Koppel-Kondensators. Auf dieser Polysiliziumschicht 32 befindet sich eine dünne Isolierschicht 33 aus Silizium-Oxid und Silizium-Nitrid, welche die Schaltung bzw. den Poly-Anschluß galvanisch von dem Elektrolyten 34 trennt. Die Gegenelektrode dieses Kondensators wird von dem Elektrolyten 34 selbst gebildet, welcher in direktem Kontakt mit der Isolierschicht 33 steht. Die Oberfläche der Anordnung ist von einer Schutzoxidschicht 35 bedeckt, die im Bereich der Kondensatoroberfläche 36 eine Öffnung 37 hat.

Wie in Fig. 3b ferner zu sehen ist, erstreckt sich die leitfähige Polysiliziumschicht 32 bis zu einem Ansatzbereich 38 für den Anschluß an die restliche Schaltung.

Der wirksame Abstand des so gebildeten Kondensators ist die Dicke der Isolierschicht 33. Das so entstandene Bauelement wirkt als Kondensator, obwohl lediglich eine seiner Seiten in herkömmlicher, fester Form vorliegt und aus einem Material besteht, in dem Elektronen für den Stromtransport verantwortlich sind. Die andere Seite hingegen ist flüssig, da sie durch den Elektrolyten 34 gebildet wird, wobei hier der Ladungstransport durch dissoziierte Ionen übernommen wird. Da für eine Wanderung sowohl von Elektronen innerhalb der Schaltung als auch von Ionen im Elektrolyten 34 letztendlich die am Ladungsträger bestehende Feldstärke maßgeblich ist und sich diese durch die Isolierschicht 33 fortsetzt, ist es möglich, einen Verschiebungsstrom durch das Bauelement fließen zu lassen. Dabei sammeln sich, wie bei herkömmlichen Kondensatoren, Ladungsträger unterschiedlichen Vorzeichens auf den Kondensator-Platten an. Der Unterschied besteht lediglich darin, daß sich auf der einen Seite beispielsweise eine negative Ladung aus Elektronen und auf der Gegenseite eine positive Ladung aus Ionen bilden.

Wie in Fig. 4a verdeutlicht ist, umfaßt die erfindungsgemäße Leitfähigkeitsmeßanordnung insgesamt vier derartiger Koppelkondensatoren $C_{K1}$, $C_{K2}$, $C_{K3}$, $C_{K4}$, die planar auf einem gemeinsamen Halbleitersubstrat 30 angeordnet sind.

Im Gegensatz zu den bei der Ausführungsform von Fig. 1 verwendeten Elektroden E1 bis E4, bei denen eine leitende Schicht direkten Kontakt zum Elektrolyten hat, kann hier kein Ladungsübertritt zwischen der Schaltung und der Flüssigkeit stattfinden. Im Gegensatz zu Meßzellen mit galvanischem Kontakt, bei denen immer ein Gleichstrompfad durch den Elektrolyten besteht, der im Fehlerfall zu dessen Elektrolyse führen kann, wird hier dieser nachteilige Effekt durch die Verwendung galvanisch getrennter Zellen vermieden.

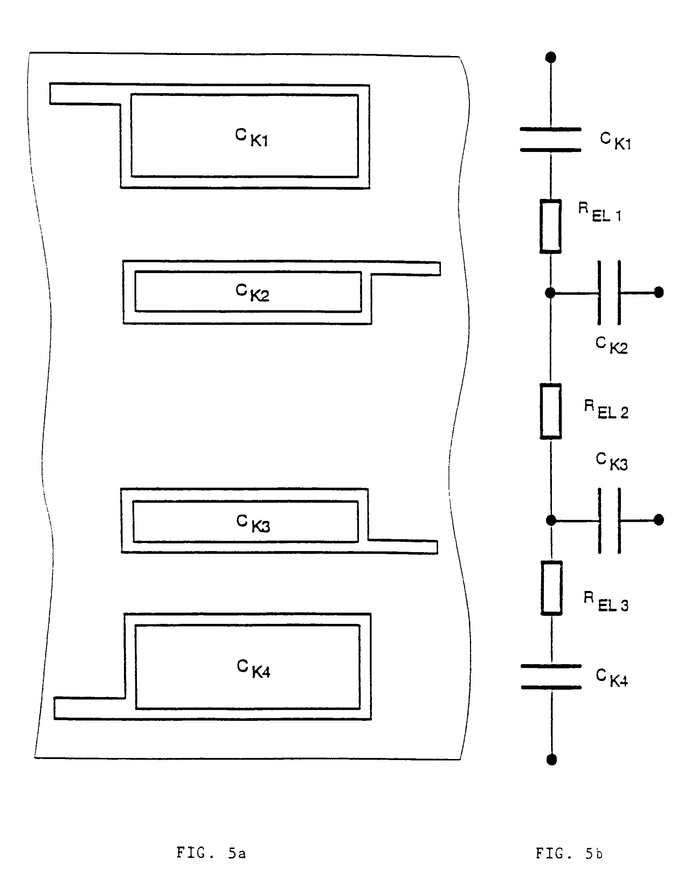

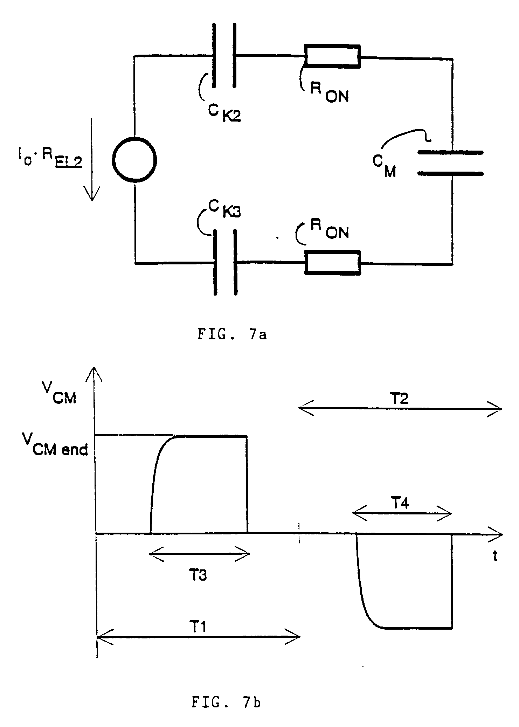

Fig. 5b zeigt das Ersatzschaltbild der Anordnung der Koppelkapazitäten gemäß Fig. 5a. Wie dort ersichtlich ist, liegen Ohm'sche Teilwiderstände $R_{EL1}$, $R_{EL2}$, $R_{EL3}$ zwischen den Koppelkapazitäten $C_{K1}$ bis $C_{K4}$. Die CMOS-Schalter $S_5$ und $S_6$ werden (in dem Ersatzschaltbild gemäß Fig. 7a) durch ihren Einschaltwiderstand $R_{ON}$ ersetzt. Der Einschaltwiderstand dieser Schalter $S_5$, $S_6$ ist nur während der Taktphase $T_3$, in der der Meßkondensator $C_M$ aufgeladen wird, von Bedeutung.

Allgemein wird bei der nachfolgenden Betrachtung ein rechteckförmiger Strom vorausgesetzt, der für jeweils gleiche Zeitdauer die Anordnungen von A nach D oder umgekehrt durchfließt. Wie in Fig. 3 gezeigt ist, wird der Strom durch eine Gleichstromquelle SQ erzeugt, deren Polarität mit Hilfe von gesteuerten Schaltern S1 bis S4 periodisch umgekehrt wird.

Das beschriebene Verfahren wird zur Erläuterung in zwei Teilvorgänge zerlegt, nämlich einerseits in die Erläuterung der Vorgänge im Zusammenhang mit der Einprägung des Meßstromes und andererseits die Messung einer dem spezifischen Widerstand des Elektrolyten proportionalen Spannung.

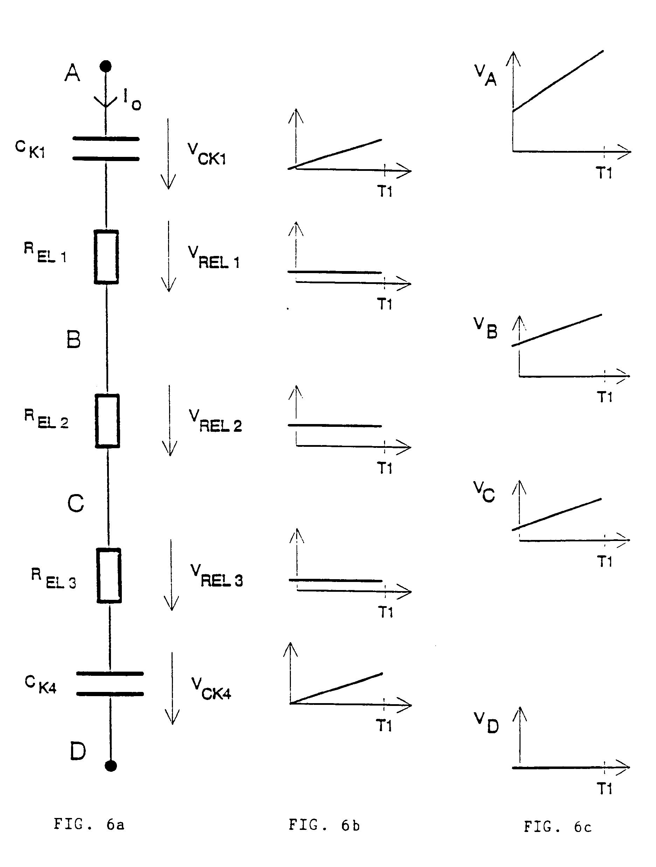

Fig. 6a zeigt das wirksame elektrische Ersatzschaltbild für das Einprägen des Meßstromes. Zur einfacheren Darstellung wird hier lediglich der Stromfluß in der Richtung von A nach D (Taktphase $T_1$) betrachtet, da sich bei umgekehrter Stromrichtung (Taktphase $T_2$) lediglich die Vorzeichen ändern. Der Punkt D wird für die betrachtete Dauer als auf Masse liegend angenommen. Der konstante Strom führt dann am Kondensator $C_{K4}$ zu einem linearen Anstieg der Spannung gemäß folgendem Zusammenhang:

$$(1) \qquad V_{CK4} = \frac{I_0 t}{C_{K4}}$$

Das dem vierten Koppelkondensator $C_{K4}$ folgende Element des elektrischen Ersatzschaltbildes, nämlich der dritte Ohm'sche Elektrolyt-Widerstand $R_{EL3}$, verursacht einen konstanten Spannungsabfall infolge des Meßstromes gemäß folgendem Zusammenhang:

$$(2) \qquad V_{REL3} = I_0 R_{EL3}$$

Ebenso führen die beiden anderen Ohm'schen Teilwiderstände $R_{EL2}$, $R_{EL1}$ zu folgenden Spannungsabfällen:

$$(3) \qquad V_{REL2} = I_0 R_{EL2}$$
$$(4) \qquad V_{REL1} = I_0 R_{EL1}$$

Die Spannung am Punkt C ergibt sich folgendermaßen als Summe der Spannungen an dem vierten Koppelkondensator $C_{K4}$ und dem dritten Elektrolyt-Widerstand $R_{EL3}$:

$$(5) \qquad V_C = V_{CK4} + V_{REL3} = \frac{I_0 t}{C_{K4}} + I_0 R_{EL3}$$

Entsprechend ergibt sich für die Spannung am Punkt B folgender Zusammenhang:

$$(6) \qquad V_B = V_{CK4} + V_{REL3} + V_{REL2} = \frac{I_0 t}{C_{K4}} + I_0 R_{EL3} + I_0 R_{EL2}$$

Der obere Kondensator $C_{K1}$ ist von gleicher Größe und Beschaffenheit wie der Kondensator $C_{K4}$ und verursacht einen ebensogroßen Spannungsabfall wie dieser, der folgendem Zusammenhang genügt:

$$(7) \qquad V_{CK1} = \frac{I_0 t}{C_{K1}}$$

Entscheidend für die weitere Auswertung ist nun, daß die Spannungen an den Punkten B und C zwar absolut rampenförmig verlaufen, ihre Differenz jedoch konstant ist und nur von dem Meßstrom und dem Elektrolyt-Widerstand abhängt. Daher gilt:

$$(8) \qquad V_B - V_C = I_0 R_{EL2}$$

Um diese Differenzspannung zu erfassen, werden zwei weitere Koppelkondensatoren $C_{K2}$ und $C_{K4}$ benutzt, die zwischen den oben beschriebenen Kondensatoren $C_{K1}$ und $C_{K4}$ angeordnet sind. Diese werden während einer Zeit $T_3$ nach dem Polaritätswechsel des Meßstromes, also nachdem sich bezüglich des Ohm'schen Spannungsabfalles am Elektrolyten stationäre Zustände eingestellt haben, über die Schalter $S_5$ und $S_6$ mit dem Meßkondensator $C_M$ verbunden. Analog dazu ist der Vorgang bei umgekehrtem Stromfluß. Dann werden innerhalb der Zeitdauer von $T_2$ während der Zeitdauer $T_4$ entsprechend die Schalter $S_7$ und $S_8$ benutzt.

Zur Analyse des Vorganges wird der Ohm'sche Spannungsabfall an dem Teilelektrolyt-Widerstand $R_{EL2}$ in Fig. 4 als Spannungsquelle dargestellt. Dies ist zulässig, obwohl durch die Aufladung des Zweiges mit dem Meßkondensator $C_M$ die ursprüngliche Stromverteilung gestört wird, da dieser Zweig nach kurzer Zeit wieder stromlos wird, so daß daraufhin die gleichen Verhältnisse vorliegen wie ohne den Meßkondensator $C_M$.

Für den Ladevorgang von $C_M$ gelten folgende Randbedingungen:

Die Aufladung erfolgt exponentiell, da nur Widerstände und Kapazitäten in dem betreffenden Kreis liegen.

Die Zeitkonstante ist definiert durch den doppelt vorhandenen Einschaltwiderstand der CMOS-Schalter sowie durch die Reihenschaltung der Koppelkapazitäten $C_{K2}$, $C_{K3}$ und der Meßkapazität $C_M$. Hierbei ist $C_{K2}$ gleich $C_{K3}$. Für die Aufladezeitkonstante $t_M$ gilt folgender Zusammenhang:

$$(9) \qquad t_M = 2 R_{ON} \frac{C_M C_{K2}}{(C_{K2} + 2C_M)}$$

Die bei der realisierten Schaltung erreichte Zeitkonstante $t_M$ liegt im Bereich von einigen 10 ns, so daß eine Aufladung der Meßkapazität $C_M$ innerhalb einer sehr kurzen Zeit verglichen mit der Dauer der Spannungsrampe von einigen 10 µs gewährleistet ist. Den Endwert der Spannung an der Meßkapazität $C_M$ erhält man aus dem kapazitiven Teilungsverhältnis der bestehenden Kondensatoren gemäß folgendem Zusammenhang:

$$(10) \qquad V_{CMEnd} = I_0 R_{EL2} \frac{C_{K2}}{(C_{K2} + 2C_M)}$$

Mit dieser Spannung $V_{CMEnd}$ steht nun ein dem Elektrolyt-Widerstand $R_{EL2}$ proportionales Meßsignal zur Verfügung. Durch die vorgegebenen geometrischen Verhältnisse der Meßanordnung ist der zweite Elektrolyt-Teilwiderstand $R_{EL2}$ über eine Konstante mit dem spezifischen Widerstand bzw. durch Kehrwertbildung mit dem spezifischen Leitwert des Elektrolyten verknüpft. Diese Konstante läßt sich quasi als eine "Zellenkonstante" der Anordnung auffassen.

Die zeitlichen Verläufe der Spannung am Meßkondensator $C_M$ sind in Fig. 7b dargestellt.

Nachdem das Meßsignal auf die Meßkapazität $C_M$ übertragen worden ist, werden die Schalter $S_5$ und $S_6$ wieder geöffnet, wobei die Ladung auf der Meßkapazität $C_M$ erhalten bleibt (vergleiche Fig. 7a). Zur Weiterverarbeitung wird sie mittels weiterer Schalter $S_9$ und $S_{10}$ in die Schalter-Kondensator-Schaltung gemäß Fig. 3 eingebracht und verstärkt. Dabei gelangt die auf dem Meßkondensator $C_M$ gespeicherte Ladung auf den Rückkoppel-Kondensator $C_R$, wobei das Kapazitätsverhältnis von $C_M$ zu $C_R$ den Verstärkungsfaktor definiert. Die Ausgangsspannung $V_{OUT}$ steht nach jedem Ladevorgang als Ausgangswert zur Verfügung. Bei Beschaltung des Operationsverstärkers OPV als Integrator, bei dem die Spannung über den Rückkopplungskondensator $C_R$ erst nach mehreren Takten durch den elften Schalter $S_{11}$ zurückgesetzt wird, kann das Ausgangssignal weiter verstärkt werden.

Bei der erfindungsgemäßen Leitfähigkeitsmeßvorrichtung sind Polarisationseffekte ausgeschlossen, können keine Elektrolysevorgänge im Elektrolyten auftreten, sind Driftfehler aufgrund einer Absorption von Ionen oder einer Verschmutzung im Bereich der Meßelemente gleichfalls ausgeschlossen bzw. stark vermindert. Der Elektrolyt ist nicht auf ein festes Potential gelegt, wodurch der Anwendungsbereich der erfindungsgemäßen Leitfähigkeitsmeßvorrichtung weiter vergrößert wird. Da der Elektrolyt nicht in Kontakt mit Metallen stehen muß, werden unerwünschte chemische Reaktionen, wie beispielsweise katalytische Reaktionen, vermieden.

**Patentansprüche**

1. Integrierbare Leitfähigkeitsmeßvorrichtung zur Messung der elektrischen Leitfähigkeit von Flüssigkeiten, mit einer Stromquellenvorrichtung (SQ, S1, S2, S3, S4), die an zwei Stromzufuhrelemente anschließbar ist, über die ein rechteckförmiger Strom in die Flüssigkeit eingespeist wird, und mit einer an zwei Spannungsmeßelementen angeschlossenen Meßschaltung (OPV, S5 - S11, CM, CR) zum Bestimmen des Spannungsabfalles in der Flüssigkeit zwischen den Spannungsmeßelementen, welcher von der elektrischen Leitfähigkeit der untersuchten Flüssigkeit abhängt, wobei die Meßschaltung eine Schalter-Kondensator-Schaltung ist, die einen Meßkondensator (C1), einen Differenzverstärker (OPV) mit einem in dessen Rückkopplungszweig angeordneten Rückkopplungskondensator (C2) und eine Schaltereinrichtung (S5 bis S11) aufweist, mittels der (S5 bis S11) die beiden Anschlüsse des Meßkondensators (C1) in zeitlicher Abhängigkeit von dem Verlauf des rechteckförmigen Stromes in einem Schaltzustand mit den Spannungselektroden (E2, E3) und in einem anderen Schaltzustand mit den beiden Eingängen des Differenzverstärkers (OPV) verbunden sind, und die Stromzufuhrelemente als Stromeinkoppelkondensatoren ($C_{K1}$, $C_{K4}$) ausgebildet sind.

2. Integrierbare Leitfähigkeitsmeßvorrichtung nach Anspruch 1, dadurch gekennzeichnet, daß die Spannungsmeßelemente als Spannungsauskoppelkondensatoren ($C_{K2}$, $C_{K3}$) ausgebildet sind.

3. Integrierbare Leitfähigkeitsmeßvorrichtung nach Anspruch 1 oder 2, dadurch gekennzeichnet, daß jeder Koppel-Kondensator ($C_{K1}$, $C_{K2}$, $C_{K3}$, $C_{K4}$) als leitende Schicht (32) auf einer isolierenden Zwischenschicht (31), die ihrerseits auf einem Halbleitersubstrat (30) liegt, ausgebildet ist und von einer isolierenden Oberflächenschicht (33) bedeckt ist.

4. Integrierbare Leitfähigkeitsmeßvorrichtung nach Anspruch 3, dadurch gekennzeichnet,
daß die isolierende Oberflächenschicht (33) aus Siliziumoxid und Siliziumnitrid besteht,
daß die leitende Schicht (32) aus Polysilizium besteht, und
daß die isolierende Zwischenschicht (33) aus Siliziumoxid besteht.

5. Integrierbare Leitfähigkeitsmeßvorrichtung nach einem der Ansprüche 1 bis 4, dadurch gekennzeichnet,
daß die Stromquelleneinrichtung eine Gleichstromquelle (SQ) aufweist, die über einen ersten, zweiten,
dritten und vierten Schalter (S1, S2, S3, S4) mit den Stromeinkoppelkondensatoren ($C_{K1}$, $C_{K4}$) in einer
ersten und einer zweiten Polung verbunden ist.

6. Integrierbare Leitfähigkeitsmeßvorrichtung nach Anspruch 5, dadurch gekennzeichnet,
daß eine Steuervorrichtung vorgesehen ist, die den ersten, zweiten, dritten und vierten Schalter (S1, S2,
S3, S4) derart ansteuert, daß sie die Stromquelle (SQ) alternierend während einer ersten Zeitdauer (T1)
in der ersten Polung und während einer zweiten Zeitdauer (T2) in der zweiten Polung mit den Stromeinkoppelkondensatoren ($C_{K1}$, $C_{K4}$) verbinden.

7. Integrierbare Leitfähigkeitsmeßvorrichtung nach Anspruch 6, dadurch gekennzeichnet,
daß die Schaltereinrichtung (S1, S2, S3, S4) einen fünften, sechsten, siebten und achten Schalter (S5,
S6, S7, S8) aufweist,
daß die Steuervorrichtung den fünften bis achten Schalter (S5, S6, S7, S8) derart ansteuert, daß sie die
Spannungauskoppelkondensatoren ($C_{K2}$, $C_{K3}$) während einer dritten Zeitdauer (T3) in einer ersten Polung
und während einer vierten Zeitdauer (T4) in einer zweiten Polung mit dem Meßkondensator (C1) verbinden, und
daß die dritte Zeitdauer (T3) innerhalb der ersten Zeitdauer (T1) und die vierte Zeitdauer (T4) innerhalb
der zweiten Zeitdauer (T2) liegen.

8. Integrierbare Leitfähigkeitsmeßvorrichtung nach Anspruch 6, dadurch gekennzeichnet,
daß die erste und zweite Zeitdauer (T1, T2) gleich lang sind, so daß der reckteckförmige Strom im zeitlichen Mittel keinen Gleichanteil aufweist.

9. Integrierbare Leitfähigkeitsmeßvorrichtung nach einem der Ansprüche 1 bis 8, dadurch gekennzeichnet,
daß die Meßschaltung eine Verstärkerschaltung (OPV, CR) aufweist, die mit dem Meßkondensator (CM)
über einen neunten und zehnten Schalter (S9, S10) verbindbar ist.

10. Integrierbare Leitfähigkeitsmeßvorrichtung nach Anspruch 9, dadurch gekennzeichnet,
daß die Steuervorrichtung den neunten und zehnten Schalter (S9, S10) derart ansteuert, daß sie die Verstärkerschaltung (OPV, CR) während einer fünften Zeitdauer (T5), die außerhalb der dritten und vierten
Zeitdauer (T3, T4) liegt, mit dem Meßkondensator (CM) verbinden.

11. Integrierbare Leitfähigkeitsmeßvorrichtung nach Anspruch 9 oder 10, dadurch gekennzeichnet,
daß die Meßschaltung einen Rückkopplungskondensator (CR) im Rückkopplungszweig der Verstärkerschaltung (OPV, CR) aufweist.

12. Integrierbare Leitfähigkeitsmeßvorrichtung nach Anspruch 11, dadurch gekennzeichnet,
daß ein elfter Schalter (S11) parallel zu dem Rückkopplungskondensator (CR) liegt, und
daß die Steuervorrichtung den elften Schalter (S11) derart ansteuert, daß der Rückkopplungskondensator (CR) nach jeder fünften Zeitdauer (T5) entladen wird.

13. Integrierbare Leitfähigkeitsmeßvorrichtung nach Anspruch 11, dadurch gekennzeichnet,
daß ein elfter Schalter (S11) parallel zu dem Rückkopplungskondensator (CR) liegt, und
daß die Steuervorrichtung den elften Schalter (S11) derart ansteuert, daß der Rückkopplungskondensator (CR) nach jeweils einer Mehrzahl von Perioden (T1, T2) entladen wird.

**Claims**

1. An integrable conductivity measuring device for measuring the electric conductivity of liquids, comprising
a current source device (SQ, S1, S2, S3, S4) adapted to be connected to two current supply elements through which a substantially square-wave current is fed into the liquid, and
a measuring circuit (OPV, S5 - S11, CM, CR) connected to two voltage measuring elements and used for determining the voltage drop in the liquid between said voltage measuring elements, said voltage drop depending on the electric conductivity of the liquid examined,
wherein the measuring circuit is a switch-capacitor circuit including a measuring capacitor (C1), a differential amplifier (OPV) having a feedback capacitor (C2) arranged in its feedback branch, and a switch means (S5 to S11) with the aid of which (S5 to S11) the two connections of the measuring capacitor (C1) are connected in time dependence on the behaviour of the square-wave current to the voltage electrodes (E2, E3) in one switching state and to the two inputs of the differential amplifier (OPV) in another switching state, and
the current supply elements are implemented as current coupling capacitors ($C_{K1}$, $C_{K4}$).

2. An integrable conductivity measuring device according to claim 1, characterized in
that the voltage measuring elements are implemented as voltage decoupling capacitors ($C_{K2}$, $C_{K3}$).

3. An integrable conductivity measuring device according to claim 1 or 2, characterized in that
each coupling and decoupling capacitor ($C_{K1}$, $C_{K2}$, $C_{K3}$, $C_{K4}$) is formed as a conductive layer (32) on an insulating intermediate layer (31), which, in turn, is positioned on a semiconductor substrate (30), and is covered by an insulating surface layer (33).

4. An integrable conductivity measuring device according to claim 3, characterized in
that the insulating surface layer (33) consists of silicon oxide and silicon nitride,
that the conductive layer (32) consists of polysilicon, and
that the insulating intermediate layer (33) consists of silicon oxide.

5. An integrable conductivity measuring device according to one of the claims 1 to 4, characterized in
that the current source device comprises a direct-current source (SQ) which is connected via first, second, third and fourth switches (S1, S2, S3, S4) to the current coupling capacitors ($C_{K1}$, $C_{K4}$) in a first and in a second polarity.

6. An integrable conductivity measuring device according to claim 5, characterized in
that a control device is provided, which controls the first, second, third and fourth switches (S1, S2, S3, S4) in such a way that they connect the current source (SQ) to the current coupling capacitors ($C_{K1}$, $C_{K4}$) alternately during a first period of time (T1) in the first polarity and during a second period of time (T2) in the second polarity.

7. An integrable conductivity measuring device according to claim 6, characterized in
that the switch means (S1, S2, S3, S4) has fifth, sixth, seventh and eighth switches (S5, S6, S7, S8), that the control device controls the fith to eighth switches (S5, S6, S7, S8) in such a way that they connect the voltage decoupling capacitors ($C_{K2}$, $C_{K3}$) to the measuring capacitor (C1) during a third period of time (T3) in a first polarity and during a fourth period of time (T4) in a second polarity, and
that the third period of time (T3) lies within the first period of time (T1) and the fourth period of time (T4) within the second period of time (T2).

8. An integrable conductivity measuring device according to claim 6, characterized in
that the first and second periods of time (T1, T2) are of equal length so that the square-wave current has no dc component averaged over time.

9. An integrable conductivity measuring device according to one of the claims 1 to 8, characterized in
that the measuring circuit is provided with an amplifier circuit (OPV, CR) which is adapted to be connected to the measuring capacitor (CM) via ninth and tenth switches (S9, S10).

10. An integrable conductivity measuring device according to claim 9, characterized in
that the control device controls said ninth and tenth switches (S9, S10) in such a way that they connect the amplifier circuit (OPV, CR) to the measuring capacitor (CM) during a fifth period of time (T5), which does not lie within said third and fourth periods of time (T3, T4).

11. An integrable conductivity measuring device according to claims 9 and 10, characterized in

that the measuring circuit is provided with feedback capacitor (CR) located in the feedback branch of the amplifier circuit (OPV, CR).

12. An integrable conductivity measuring device according to claim 11, characterized in
    that an eleventh switch (S11) is connected in parallel to the feedback capacitor (CR), and
    that the control device controls the eleventh switch (S11) in such a way that the feedback capacitor (CR) is discharged after each fifth period of time (T5).

13. An integrable conductivity measuring device according to claim 11, characterized in
    that an eleventh switch (S11) is connected in parallel to the feedback capacitor (CR), and
    that the control device controls the eleventh switch (S11) in such a way that the feedback capacitor (CR) is discharged whenever a plurality of periods (T1, T2) has elapsed.

**Revendications**

1. Dispositif intégrable de mesure de conductivité destiné à mesurer la conductivité électrique de liquides,
    avec un dispositif de source de courant (SQ, S1, S2, S3, S4) pouvant être raccordé à deux éléments d'alimentation de courant par lesquels un courant rectangulaire est alimenté dans le liquide, et
    avec un circuit de mesure (OPV, S5 à S11, CM, CR) raccordé à deux éléments de mesure de tension, destiné à déterminer la chute de tension dans le liquide entre les éléments de mesure de tension, laquelle dépend de la conductivité électrique du liquide examiné,
    le circuit de mesure étant un circuit commutateur-condensateur qui présente un condensateur de mesure (C1), un amplificateur différentiel (OPV) avec un condensateur de réaction (C2) disposé dans son branchement de réaction, et un dispositif de commutation (S5 à S11) à l'aide duquel (S5 à S11) les deux connexions du condensateur de mesure (C1) sont raccordées, en fonction temporelle de l'évolution du courant rectangulaire, dans un état de commutation, aux électrodes de tension (E2, E3) et, dans un autre état de commutation, aux deux entrées de l'amplificateur différentiel (OPV), et
    les éléments d'alimentation de courant étant réalisés sous forme de condensateurs de couplage de courant ($C_{K1}$, $C_{K4}$).

2. Dispositif intégrable de mesure de conductivité suivant la revendication 1, caractérisé en ce que les éléments de mesure de tension sont réalisés sous forme de condensateurs de découplage de tension ($C_{K2}$, $C_{K3}$).

3. Dispositif intégrable de mesure de conductivité suivant la revendication 1 ou 2, caractérisé en ce que chaque condensateur de couplage ($C_{K1}$, $C_{K2}$, $C_{K3}$, $C_{K4}$) est réalisé sous forme de couche conductrice (32) sur une couche intermédiaire isolante (31), qui, à son tour, se trouve sur un substrat semiconducteur (30), et est recouvert d'une couche superficielle isolante (33).

4. Dispositif intégrable de mesure de conductivité suivant la revendication 3, caractérisé en ce
    que la couche superficielle isolante (33) est réalisée en oxyde de silicium et nitrure de silicium,
    que la couche conductrice (32) est réalisée en polysilicium, et
    que la couche intermédiaire isolante (33) est réalisée en oxyde de silicium.

5. Dispositif intégrable de mesure de conductivité suivant l'une des revendications 1 à 4, caractérisé en ce que le dispositif de source de courant présente une source de courant continu (SQ) qui est reliée, par un premier, un second, un troisième et un quatrième commutateur (S1, S2, S3, S4) aux condensateurs de couplage de courant ($C_{K1}$, $C_{K4}$), selon une première et une seconde polarité.

6. Dispositif intégrable de mesure de conductivité suivant la revendication 5, caractérisé en ce qu'il est prévu un dispositif de commande qui commande le premier, le second, le troisième et le quatrième commutateur (S1, S2, S3, S4) de telle manière qu'ils relient la source de courant (SQ) aux condensateurs de couplage de courant ($C_{K1}$, $C_{K4}$) alternativement pendant une première période (T1) selon une première polarité et pendant une seconde période (T2) selon la seconde polarité.

7. Dispositif intégrable de mesure de conductivité suivant la revendication 6, caractérisé en ce
    que le dispositif de commutation (S1, S2, S3, S4) présente un cinquième, un sixième, un septième

**10**

et un huitième commutateur (S5, S6, S7, S8),

que le dispositif de commande commande les cinquième à huitième commutateurs (S5, S6, S7, S8) de telle manière qu'ils relient les condensateurs de découplage de tension ($C_{K2}$, $C_{K3}$) au condensateur de mesure (C1), pendant une trosième période (T3) selon une première polarité et pendant une quatrième période (T4) selon une seconde polarité, et

que la troisième période (T3) se situe dans les limites de la première période (T1) et que la quatrième période (T4) se situe dans les limites de la seconde période (T2).

8. Dispositif intégrable de mesure de conductivité suivant la revendication 6, caractérisé en ce que les première et seconde périodes (T1, T2) sont de même durée, de sorte que le courant rectangulaire ne présente pas de fraction continue en moyenne dans le temps.

9. Dispositif intégrable de mesure de conductivité suivant l'une des revendications 1 à 8, caractérisé en ce que le circuit de mesure présente un circuit amplificateur (OPV, CR) qui peut être relié au condensateur de mesure (CM) par l'intermédiaire d'un neuvième et d'un dixième commutateur (S9, S10).

10. Dispositif intégrable de mesure de conductivité suivant la revendication 9, caractérisé en ce que le dispositif de commande commande les neuvième et dixième commutateurs (S9, S10) de telle manière qu'ils relient le circuit amplificateur (OPV, CR) au condensateur de meusre (CM) pendant une cinquième période (T5) qui se situe en-dehors des troisième et quatrième périodes (T3, T4).

11. Dispositif intégrable de mesure de conductivité suivant la revendication 9 ou 10, caractérisé en ce que le circuit de mesure présente un condensateur de réaction (CR) dans le branchement de réaction du circuit amplificateur (OPV, CR)

12. Dispositif intégrable de mesure de conductivité suivant la revendication 11, caractérisé en ce qu'un onzième commutateur (S11) se situe en parallèle avec le condensateur de réaction (CR), et que le dispositif de commande commande l'onzième commutateur (S11) de telle manière que le condensateur de réaction (CR) est déchargé après chaque cinquième période (T5).

13. Dispositif intégrable de mesure de conductivité suivant la revendication 11, caractérisé en ce qu'un onzième commutateur (S11) se situe en parallèle avec le condensateur de réaction (CR), et que le dispositif de commande commande l'onzième commutateur (S11) de telle manière que le condensateur de réaction (CR) est déchargé après chaque fois une pluralité de périodes (T1, T2).

FIG.1

a) T1

b) T2

c) V1

d) T3

e) T4

f) T5

g) $V_{C1}$

h) $V_{OUT}$

FIG.2

FIG. 3a

FIG. 3b

FIG. 4

FIG. 5a

FIG. 5b

FIG. 6a  FIG. 6b  FIG. 6c

FIG. 7a

FIG. 7b